# EUROPÄISCHE PATENTANMELDUNG

(11) **EP 1 632 949 A2**
(43) Veröffentlichungstag der Anmeldung: **08.03.2006**
(21) Anmeldenummer: 05019017.2
(22) Anmeldetag: 01.09.2005
(51) Int. Cl.: G11C 7/22, G11C 7/10, G11C 11/4076

(54) **Integrierter Halbleiterspeicher mit Takterzeugung**

(30) Priorität: 06.09.2004 DE 102004043035
(71) Anmelder: Infineon Technologies AG, 81669 München (DE)
(72) Erfinder: Sommer, Michael Bernhard, 83064 Raubling (DE)
(74) Vertreter: Epping - Hermann - Fischer

(57) **Zusammenfassung**

Ein integrierter Halbleiterspeicher umfasst eine Taktgeberschaltung (10), die zur Erzeugung eines internen Taktsignals (Cint) von einem externen Taktsignal (Cext) angesteuert wird. Die Taktgeberschaltung (10) erzeugt einen Pegel (PE1, PE2) des internen Taktsignals, wenn sie von dem externen Taktsignal für die Dauer einer Empfindlichkeitszeit (TE) von dem externen Taktsignal mit einem Pegel (PE1, PE2) angesteuert wird. Das interne Taktsignal (Cint) weist gegenüber dem externen Taktsignal (Cext) eine höhere Frequenz- und Phasenstabilität auf. Der integrierte Halbleiterspeicher umfasst des Weiteren eine Steuerschaltung (20) zur Steuerung der Taktgeberschaltung (10), die ebenfalls von dem externen Taktsignal angesteuert wird. In Abhängigkeit von einer Frequenz des externen Taktsignals verändert die Steuerschaltung (20) die Empfindlichkeitszeit (TE) der Taktgeberschaltung (10). Dadurch wird verhindert, dass ein verrauschtes externes Taktsignal (Cext) zu unkontrolliertem Schaltverhalten einer internen Chiplogik des integrierten Halbleiterspeichers führt.

## Beschreibung

Bei integrierten Halbleiterspeichern, beispielsweise DRAM (Dynamic Random Access Memory)-Halbleiterspeichern, werden Speichervorgänge im allgemeinen zu steigenden und fallenden Flanken von Taktsignalen ausgelöst. Der integrierte Halbleiterspeicher wird dazu von einem Speichercontroller mit einem externen Taktsignal angesteuert. Das externe Taktsignal wird in dem Halbleiterspeicher einer Taktgeberschaltung zugeführt. Die Taktgeberschaltung erzeugt aus den ihr extern zugeführten Taktsignalen ein internes Taktsignal, das eine höhere Frequenz- und Phasenstabilität aufweist, als das externe Taktsignal.

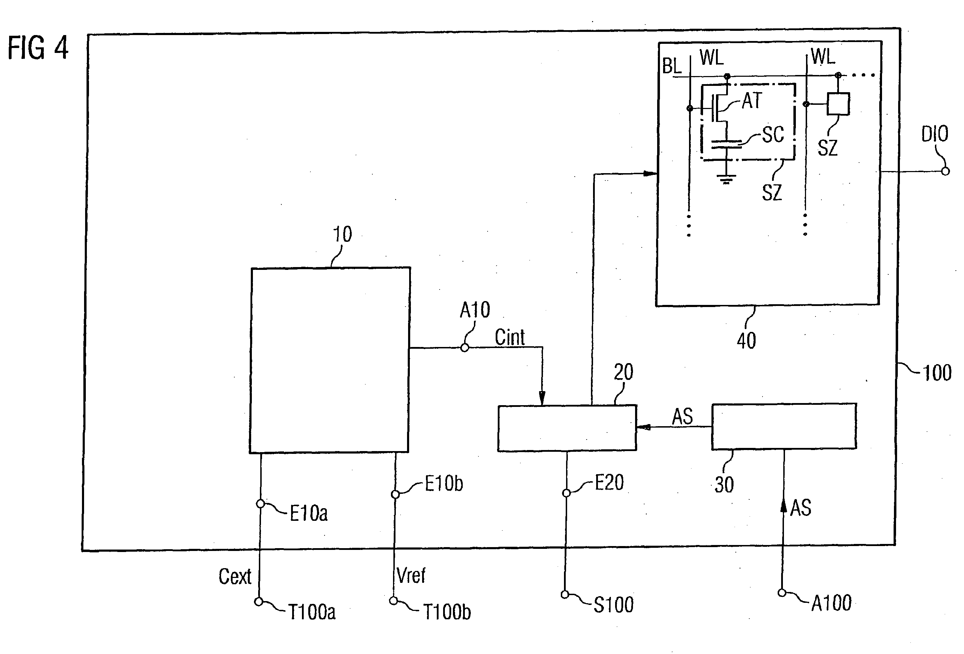

Figur 4 zeigt einen integrierten Halbleiterspeicher 100 mit einer Taktgeberschaltung 10 zur Erzeugung eines internen Taktsignals Cint. Der integrierte Halbleiterspeicher weist einen Taktanschluss T100a zum Anlegen eines externen Taktsignals Cext und einen Taktanschluss T100b zum Anlegen eines Referenzsignals Vref auf. Über Eingangsanschlüsse E10a und E10b, die mit den Taktanschlüssen T100a und T100b verbunden sind, werden der Taktgeberschaltung 10 das externe Taktsignal Cext und das Referenzsignal Vref zugeführt. Nach Auswertung der beiden Signale erzeugt die Taktgeberschaltung 10 an einem Ausgangsanschluss A10 das interne Taktsignal Cint, das einer Steuerschaltung 20 zugeführt wird. Die Steuerschaltung 20 ist über einen Eingangsanschluss E20 mit einem Steueranschluss S100 des integrierten Halbleiterspeichers verbunden. Zum Speichern von Daten beziehungsweise zum Auslesen von Daten wird die Steuerschaltung 20 an dem Steueranschluss S100 mit externen Steuersignalen angesteuert. Die externen Steuersignale werden dabei synchron zu steigenden und fallenden Flanken des internen Taktsignals Cint von der Steuerschaltung 20 eingelesen und ausgewertet. Der integrierte Halbleiterspeicher weist des Weiteren ein Adressregister 30, das eingangsseitig mit einem Adressanschluss A100 zum Anlegen von Adresssignalen AS verbunden ist, auf. Die Adresssignale AS werden in dem Adressregister 30 zwischengespeichert und der Steuerschaltung 20 zugeführt.

Für einen Lese- und Schreibzugriff wertet die Steuerschaltung 20 zu steigenden und fallenden Taktflanken des internen Taktsignals C die Adresssignale AS aus und steuert in einem Speicherzellenfeld 40 zu den Adressen zugehörige Speicherzellen SZ an. In dem Speicherzellenfeld 40 sind exemplarisch zwei Speicherzellen SZ dargestellt, die als DRAM-Speicherzellen ausgebildet sind. Die DRAM-Speicherzellen SZ weisen einen Speicherkondensator SC auf, der über einen Auswahltransistor AT mit einer Bitleitung BL leitend verbunden werden kann. Zum Auslesen eines Datenwertes aus der Speicherzelle bzw. zum Einschreiben eines Datenwertes in die Speicherzelle wird der Auswahltransistor über ein Signal auf einer Wortleitung WL, das von der Steuerschaltung 20 erzeugt wird, leitend gesteuert. Bei einem Lesezugriff wird die Speicherinformation über die Bitleitung BL an einem Datenanschluss DIO ausgelesen. Bei einem Schreibzugriff wird ein einzuschreibender Datenwert an den Datenanschluss DIO angelegt und über die Bitleitung BL in die Speicherzelle eingeschrieben.

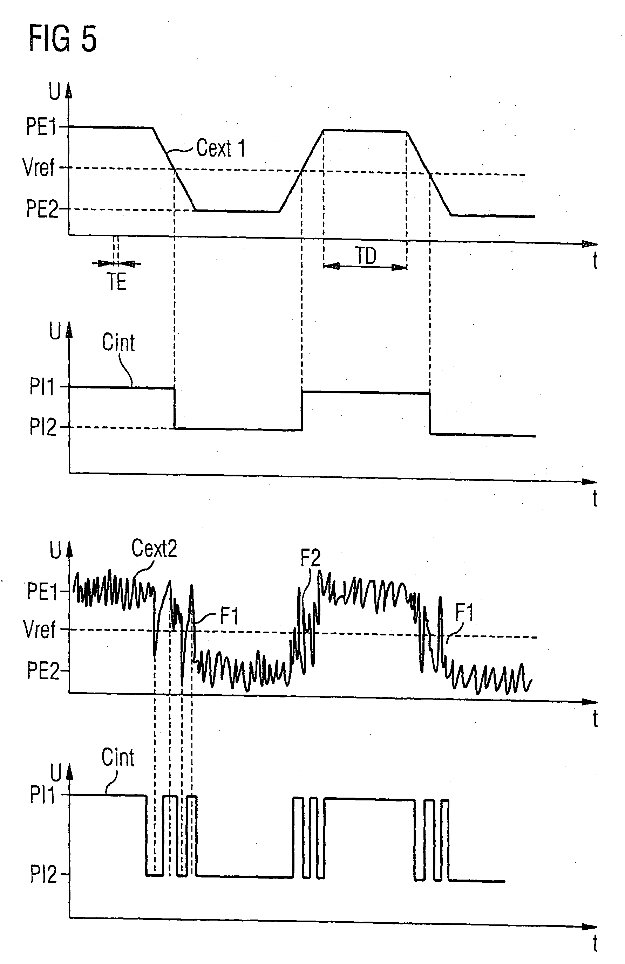

Figur 5 verdeutlicht die Funktionsweise der Taktgeberschaltung 10. Die Diagramme zeigen jeweils den Verlauf einer Spannungsamplitude U von externen und internen Taktsignalen über einer Zeit t.

Das erste Diagramm der Figur 5 zeigt den Verlauf eines externen Taktsignal Cext1. Die Spannungsamplitude schwankt dabei während einer Impulsdauer TD zwischen einem hohen ersten Taktsignalpegel PE1 und einem niedrigen zweiten Taktsignalpegel PE2.

Das zweite Diagramm der Figur 5 zeigt den Verlauf des von der Taktgeberschaltung 10 erzeugten internen Taktsignals Cint bei einer Ansteuerung mit dem externen Taktsignal Cext1 des ersten Diagramms der Figur 5. Die Spannungsamplitude des internen Taktsignals schwankt dabei zwischen einem ersten hohen Pegel PI1 und einem zweiten niedrigen Pegel PI2. Wenn die Spannungsamplitude des externen Taktsignals Cext1 einen Empfindlichkeitspegel Vref der Taktgeberschaltung 10 überschreitet, erzeugt die Taktgeberschaltung 10 das interne Taktsignal mit dem hohen Pegel PI1. Wenn hingegen die Spannungsamplitude des externen Taktsignals Cext1 den Empfindlichkeitspegel Vref unterschreitet (crossing point), erzeugt die Taktgeberschaltung 10 das interne Taktsignal mit dem niedrigen Pegel PI2.

Im ersten Diagramm der Figur 5 ist ferner eine Empfindlichkeitszeit TE der Taktgeberschaltung 10 eingezeichnet. Die Empfindlichkeitszeit TE ist dabei die Zeit, mit der die Spannungsamplitude des externen Taktsignals mindestens an der Taktgeberschaltung 10 anliegen muss, damit die Taktgeberschaltung 10 den ersten oder zweiten Pegel des internen Taktsignals Cint erzeugen kann. Eine Änderung der Amplitude des externen Taktsignals oberhalb oder unterhalb des Wertes des Referenzsignals wird also von der Taktgeberschaltung 10 nur dann als Wechsel zwischen den beiden Pegeln des internen Taktsignals PI1 und PI2 interpretiert, wenn das externe Taktsignal mindestens für die Zeitspanne der Empfindlichkeitszeit TE einen Amplitudenwert oberhalb oder unterhalb des Referenzsignals Vref annimmt.

Das dritte Diagramm der Figur 5 zeigt ein externes Taktsignal Cext2, das gegenüber dem externen Taktsignal Cext1 ein geringeres Signal-/Rauschverhältnis aufweist. Das vierte Diagramm der Figur 5 zeigt den Verlauf des internen Taktsignals Cint, wenn die Taktgeberschaltung 10 von dem verrauschten Signalpegel des externen Taktsignals Cext2 des Diagramms 3 angesteuert wird. Das interne Taktsignal Cint zeigt insbesondere an den steigenden und fallenden Flanken F1 und F2 des externen Taktsignals Cext2 mehrere Wechsel zwischen dem hohen und niedrigen Pegel des internen Taktsignals PI1 und PI2. Diese hochfrequenten Änderungen des internen Taktsignals kommen dadurch zustande, dass die Signalamplitude des verrauschten externen Taktsignals Cext2 im Bereich der steigenden und fallenden Flanken mehrmals oberhalb beziehungsweise unterhalb dem Pegel des Referenzsignals Vref liegt. Das Eingangsrauschen (Jitter) des externen Taktsignals führt dadurch zu einem unkontrollierten Schaltverhalten der internen Chiplogik.

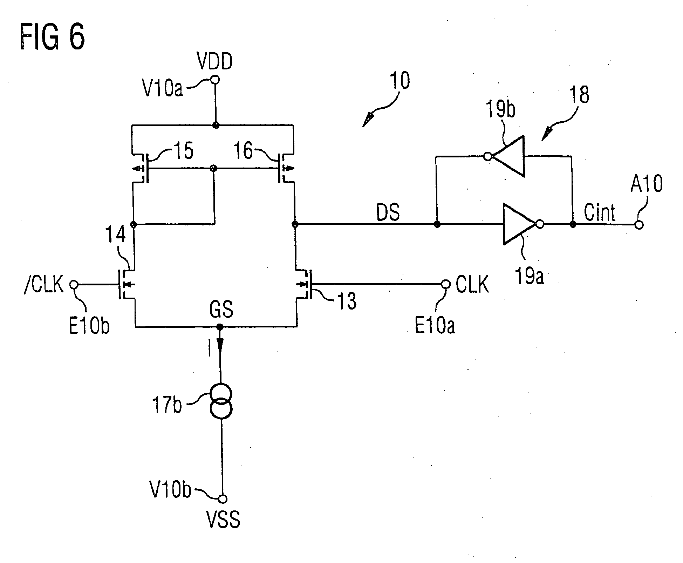

Figur 6 zeigt eine dem Stand der Technik entsprechende Ausführungsform der Taktgeberschaltung 10. Die Taktgeberschaltung ist als ein Differenzverstärker ausgebildet, der zwischen einen Anschluss V10a zum Anlegen einer Versorgungsspannung VDD und einen Anschluss V10b zum Anlegen einer Bezugsspannung VSS geschaltet ist. Der Differenzverstärker weist einen ersten Eingangstransistor 13, der mit seinem Steueranschluss an den Eingangsanschluss E10a der Taktgeberschaltung angeschlossen ist, und einen zweiten Eingangstransistor 14, der mit seinem Steueranschluss an den Eingangsanschluss E10b der Taktgeberschaltung angeschlossen ist, auf.

Im Gegensatz zu der vereinfachten Ausführungsform der Taktgeberschaltung der Figur 4 wird der Differenzverstärker in der Figur 6 von einem ersten externen Taktsignal CLK und einem dazu komplementären externen Taktsignal /CLK angesteuert. Eine solche Ansteuerung wird im Allgemeinen in einer Rechnerapplikation verwendet, wenn der integrierte Halbleiterspeicher beispielsweise von einem Speichercontroller angesteuert wird. Die Taktgeberschaltung erzeugt einen Pegelübergang Low nach High beziehungsweise High nach Low, wenn der Verlauf der Amplitude des ersten externen Taktsignals CLK den Verlauf der Amplitude des zweiten externen Taktsignals / CLK schneidet (crossing point). Eine Stromquelle 17b erzeugt an einem gemeinsamen Anschluss GS der Eingangstransistoren 13 und 14 einen Strom I. Des Weiteren sind die Eingangstransistoren 13 und 14 über eine aktive Last aus den Transistoren 15 und 16, die als Stromspiegel verschaltet sind, mit dem Anschluss V10a zum Anlegen der Versorgungsspannung VDD verbunden. Der Differenzverstärker erzeugt ausgangsseitig ein Ausgangssignal DS, das einem Latch 18 zugeführt wird. Das Latch umfasst zwei rückgekoppelte Inverter 19a und 19b, die mit dem Ausgangsanschluss A10 der Taktgeberschaltung 10 verbunden sind. Der Inverter 19a erzeugt ausgangsseitig den hohen oder niedrigen Pegel des internen Taktsignals Cint. Er ist im allgemeinen als ein Verstärker mit einer hohen Verstärkung ausgebildet, wohingegen der Inverter 19b als ein Verstärker mit einer niedrigen Verstärkung ausgebildet ist. Die Rückkopplung über den Inverter 19b wirkt als eine Mitkopplung. Durch die Mitkopplung wird das Umschalten des Differenzverstärkers bei kurzeitigen Amplitudenschwankungen des Eingangstaktsignals CLK vermieden.

Durch die beschriebene Schaltung kann die Erzeugung ungewollter Taktsignalübergänge des internen Taktsignals infolge eines verrauschten externen Eingangstaktsignals deutlich reduziert werden. Der Nachteil dieser Lösung des Problems liegt jedoch in der Mitkopplung, die zu einer verminderten Empfindlichkeit des Differenzverstärkers in Bezug auf Pegelschwankungen des externen Taktsignals an seinen Eingangsanschlüssen E10a und E10b führt. Bei schwachen externen Taktsignalen, die einen niedrigen High-Pegel beziehungsweise einen hohen Low-Pegel aufweisen, werden die High-Low- oder Low-High-Übergänge des externen Taktsignals von dem Differenzverstärker nicht mehr erkannt. Des Weiteren wird die Frequenz des internen Taktsignals, die mit dem Differenzverstärker 10 erzeugt werden kann, durch die Stärke der Rückführung begrenzt. Die Taktgeberschaltung wird dadurch verlangsamt.

Nachteilig ist auch, dass der sogenannte Duty-Cycle der Taktgeberschaltung, der das Verhältnis von High-/Low-Zeiten kennzeichnet, durch die Mitkopplung sehr prozessabhängig wird. Änderungen im Sättigungsstrom von p-Kanal- und/oder n-Kanal-Transistoren der Inverter 19a und 19b machen die Rückführung des hohen und niedrigen Pegels bei der Mitkopplung unterschiedlich stark. Dadurch wird der Duty-Cycle für schwache oder sehr hochfrequente externe Taktsignale erheblich verschlechtert.

Problematisch wirkt sich die Prozessabhängigkeit der Rückführung auch insbesondere dann aus, wenn der Differenzverstärker 10, wie in der Figur 4 gezeigt, an seinem zweiten Eingangstransistor 14 nicht vom dem komplementären externen Taktsignal /CLK sondern von einem konstanten Referenzsignal Vref angesteuert wird. Integrierte Halbleiterspeicher werden insbesondere zu Testzwecken von Testsystemen an einem der Taktanschlüsse von einem konstanten Pegel eines Referenzsignals angesteuert.

Die Aufgabe der vorliegenden Erfindung ist es, einen integrierten Halbleiterspeicher anzugeben, bei dem die Erzeugung eines internen Taktsignals einer Taktgeberschaltung an eine Güte des externen Taktsignals angepasst ist. Eine weitere Aufgabe der vorliegenden Erfindung ist es, ein Verfahren zum Betreiben eines integrierten Halbleiterspeichers anzugeben, bei dem die Erzeugung eines internen Taktsignals an die Güte eines externen Taktsignals angepasst ist.

Die Aufgabe bezüglich des integrierten Halbleiterspeichers wird gelöst durch einen integrierten Halbleiterspeicher mit einem Taktanschluss zum Anlegen eines externen Taktsignals, das einen Taktsignalpegel annimmt. Der integrierte Halbleiterspeicher umfasst des Weiteren eine Taktgeberschaltung, die zur Erzeugung eines internen Taktsignals von dem externen Taktsignal angesteuert wird. Die Taktgeberschaltung ist dabei derart ausgebildet, dass sie das interne Taktsignal mit einem ersten Pegel erzeugt, wenn der Taktsignalpegel des externen Taktsignals oberhalb eines Empfindlichkeitspegels der Taktgeberschaltung liegt und sie von dem Taktsignalpegel des externen Taktsignals mindestens für die Dauer einer Empfindlichkeitszeit der Taktgeberschaltung angesteuert wird. Darüber hinaus ist die Taktgeberschaltung derart ausgebildet, dass sie das interne Taktsignal mit einem zweiten Pegel erzeugt, wenn der Taktsignalpegel des externen Taktsignals unterhalb des Empfindlichkeitspegels liegt und die von dem Taktsignalpegel des externen Taktsignals mindestens für die Dauer einer Empfindlichkeitszeit der Taktgeberschaltung angesteuert wird. Der integrierte Halbleiterspeicher weist des Weiteren eine Steuerschaltung zur Steuerung der Taktgeberschaltung auf, die von dem externen Taktsignal angesteuert wird. Erfindungsgemäß ist die Steuerschaltung derart ausgebildet, dass sie die Empfindlichkeitszeit der Taktgeberschaltung verändert.

Die Taktgeberschaltung reagiert also ausschließlich dann auf Schwankungen des externen Taktsignals, wenn der Taktsignalpegel des externen Taktsignals mindestens für die Dauer der Empfindlichkeitszeit oberhalb oder unterhalb des Empfindlichkeitspegels der Taktgeberschaltung liegt. Erfindungsgemäß ist die Empfindlichkeitszeit der Taktgeberschaltung veränderbar. Wenn die Empfindlichkeitszeit der Taktgeberschaltung klein eingestellt ist, reagiert die Taktgeberschaltung mit einer Pegeländerung des von ihr erzeugten internen Taktsignals, wenn sie von kurzzeitigen Pegelschwankungen des externen Taktsignals oberhalb bzw. unterhalb ihres Empfindlichkeitspegels angesteuert wird. Wenn die Empfindlichkeitszeit der Taktgeberschaltung hingegen groß eingestellt ist, reagiert sie lediglich mit Änderungen des internen Taktsignalpegels, wenn sie von langfristigen externen Taktsignalschwankungen angesteuert wird. Ein hochfrequenter Jitter, der dem externen Taktsignal überlagert ist, wird somit von der Taktgeberschaltung nicht in interne Taktsignalpegeländerungen umgewandelt.

Gemäß einer Weiterbildung des erfindungsgemäßen integrierten Halbleiterspeichers ist die Steuerschaltung von einem ersten externen Taktsignal und von einem zweiten externen Taktsignal ansteuerbar. Das erste externe Taktsignal weist dabei ein größeres Signal-/Rauschverhältnis auf als das zweite externe Taktsignal. Erfindungsgemäß ist die Steuerschaltung derart ausgebildet, dass sie bei einer Ansteuerung mit dem ersten externen Taktsignal die Empfindlichkeitszeit der Taktgeberschaltung verkürzt und bei einer Ansteuerung mit dem zweiten externen Taktsignal die Empfindlichkeitszeit der Taktgeberschaltung verlängert.

Gemäß einer Weiterbildung des erfindungsgemäßen integrierten Halbleiterspeichers weist das erste externe Taktsignal eine höhere Frequenz- und Phasenstabilität auf als das zweite externe Taktsignal. Die Steuerschaltung ist derart ausgebildet, dass sie bei einer Ansteuerung mit dem ersten externen Taktsignal die Empfindlichkeitszeit der Taktgeberschaltung verkürzt und bei einer Ansteuerung mit dem zweiten externen Taktsignal die Empfindlichkeitszeit der Taktgeberschaltung verlängert.

Bei einer Ansteuerung des integrierten Halbleiterspeichers mit einem externen Taktsignal, das qualitativ hochwertig ist, also sich durch ein großes Signal-/Rauschverhältnis bzw. eine hohe Frequenz- und Phasenstabilität auszeichnet, wird die Empfindlichkeitszeit der Taktgeberschaltung von der Steuerschaltung verkürzt. Die Taktgeberschaltung reagiert damit schneller auf Schwankungen des externen Taktsignals. Dies bedeutet, dass sie beispielsweise einen niedrigen internen Taktsignalpegel erzeugt, wenn sie von einer sehr kurzfristigen Schwankung des externen Taktsignals, der unterhalb ihrem Empfindlichkeitspegel liegt, angesteuert wird. Umgekehrt erzeugt sie einen hohen internen Taktsignalpegel, wenn sie von einer kurzfristigen Schwankung des externen Taktsignalpegels angesteuert wird, der oberhalb ihres Empfindlichkeitspegels liegt. Ein hochfrequentes, nicht verrauschtes externes Taktsignal kann somit in ein hochfrequentes internes Taktsignal umgesetzt werden.

Wenn der integrierte Halbleiterspeicher von einem qualitativ schlechten externen Taktsignal angesteuert wird, also beispielsweise von einem externen Taktsignal mit einem kleinen Signal-/Rauschverhältnis bzw. einer geringen Frequenz- und Phasenstabilität, so verlängert die Steuerschaltung die Empfindlichkeitszeit der Taktgeberschaltung. Dadurch wird sichergestellt, dass die Taktgeberschaltung ungewollten Pegelschwankungen, wie sie bei einem verrauschten externen Taktsignal auftreten, nicht mit internen Taktsignalpegeländerungen folgt. Lediglich längerfristige Änderungen des externen Taktsignalpegels ober- bzw. unterhalb ihres Empfindlichkeitspegels werden von der Taktgeberschaltung in interne Taktsignalpegeländerungen umgesetzt. Es wird somit verhindert, dass ein dem externen Taktsignal überlagertes hochfrequentes Rauschen zu einem ungewollten Schaltverhalten der Taktgeberschaltung führt.

Insbesondere beim Testen eines integrierten Halbleiterspeichers wird dieser von einem Testsystem mit einem qualitativ schlechten externen Taktsignal angesteuert. Dieses externe Taktsignal zeichnet sich neben dem kleinen Signal-/Rauschverhältnis und der niedrigen Frequenz- und Phasenstabilität im Allgemeinen durch eine niedrige Frequenz aus. Gemäß einer anderen Ausführungsform der Erfindung wertet daher die Steuerschaltung das externe Taktsignal, von dem sie angesteuert wird, bezüglich dessen Frequenz aus. Wenn sie von einem externen Taktsignal mit einer niedrigen Frequenz angesteuert wird, also beispielsweise von dem verrauschten externen Taktsignal, das von einem Tester vorgegeben wird, verlängert sie die Empfindlichkeitszeit der Taktgeberschaltung. Qualitativ hochwertige Taktsignale werden beispielsweise von einem Speichercontroller im Allgemeinen mit einer hohen Frequenz erzeugt. Gemäß der Erfindung ist die Steuerschaltung daher derart ausgebildet, dass sie bei einer Ansteuerung mit einem externen Taktsignal, das eine hohe Frequenz aufweist, die Empfindlichkeitszeit der Taktgeberschaltung verkürzt.

Gemäß einer anderen Ausführungsform des integrierten Halbleiterspeichers weist die Taktgeberschaltung eine erste Taktschaltung und eine zweite Taktschaltung auf. Die erste Taktschaltung weist eine kleinere Empfindlichkeitszeit auf als die zweite Taktschaltung. Die Taktgeberschaltung ist derart ausgebildet, dass sie das interne Taktsignal durch die erste Taktschaltung erzeugt, wenn die Steuerschaltung von dem ersten externen Taktsignal angesteuert wird, und sie das interne Taktsignal durch die zweite Taktschaltung erzeugt, wenn die Steuerschaltung von dem zweiten externen Taktsignal angesteuert wird.

Nach einem weiteren Merkmal der Erfindung weist die Taktgeberschaltung einen Differenzverstärker auf. Der Differenzverstärker umfasst einen ersten Eingangstransistor, einen zweiten Eingangstransistor und eine steuerbare Stromquelle, die mit einem gemeinsamen Anschluss des ersten und zweiten Eingangstransistors verbunden ist. Die Taktgeberschaltung ist in dieser Ausführungsform derart ausgebildet, dass die steuerbare Stromquelle einen hohen Strom an dem gemeinsamen Anschluss des ersten und zweiten Eingangstransistors erzeugt, wenn die Steuerschaltung von dem ersten externen Taktsignal angesteuert wird. Die steuerbare Stromquelle erzeugt einen niedrigen Strom an dem gemeinsamen Anschluss des ersten und zweiten Eingangstransistors, wenn die Steuerschaltung von dem zweiten externen Taktsignal angesteuert wird.

Im Folgenden wird ein Verfahren zur Erzeugung eines Taktsignals zum Betreiben eines integrierten Halbleiterspeichers angegeben, das ebenfalls das Problem löst.

Vorgesehen wird ein integrierter Halbleiterspeicher, der von einem externen Taktsignal ansteuerbar ist, das einen Taktsignalpegel annimmt. Der integrierte Halbleiterspeicher weist eine erste Taktschaltung mit einer ersten Empfindlichkeitszeit und einem Empfindlichkeitspegel auf, bei dem die erste Taktschaltung ausgangsseitig ein internes Taktsignal mit einem ersten Pegel erzeugt, wenn sie mindestens für die Dauer der ersten Empfindlichkeitszeit von dem Taktsignalpegel des externen Taktsignals angesteuert wird, der oberhalb des Empfindlichkeitspegels der ersten Taktschaltung liegt, und ein internes Taktsignal mit einem zweiten Pegel erzeugt, wenn sie mindestens für die Dauer der ersten Empfindlichkeitszeit von dem Taktsignalpegel des externen Taktsignals angesteuert wird, der unterhalb des Empfindlichkeitspegels der ersten Taktschaltung liegt. Des Weiteren umfasst der integrierte Halbleiterspeicher eine zweite Taktschaltung mit einer zweiten Empfindlichkeitszeit und einem Empfindlichkeitspegel, bei dem die zweite Taktschaltung ausgangsseitig das interne Taktsignal mit dem ersten Pegel erzeugt, wenn sie mindestens für die Dauer der zweiten Empfindlichkeitszeit von dem Taktsignalpegel des externen Taktsignals angesteuert wird, der oberhalb des Empfindlichkeitspegels der zweiten Taktschaltung liegt, und ein internes Taktsignal mit einem zweiten Pegel erzeugt, wenn sie mindestens für die Dauer der zweiten Empfindlichkeitszeit von dem Taktsignalpegel des externen Taktsignals angesteuert wird, der unterhalb des Empfindlichkeitspegels der zweiten Taktschaltung liegt. Die erste Empfindlichkeitszeit der ersten Taktschaltung soll dabei kleiner sein als die zweite Empfindlichkeit der zweiten Taktschaltung. Der integrierte Halbleiterspeicher ist von einem ersten externen Taktsignal mit einer hohen Frequenz und einem zweiten externen Taktsignal mit einer niedrigen Frequenz ansteuerbar. Das erfindungsgemäße Verfahren sieht nunmehr das Setzen eines Steuerbits in einem Register mit einem ersten Zustand vor. Anschließend wird der integrierte Halbleiterspeicher mit dem ersten externen Taktsignal angesteuert. Das mit dem ersten Zustand gesetzte Steuerbit bewirkt, dass zur Erzeugung des internen Taktsignals die erste Taktschaltung aktiviert wird. Das erfindungsgemäße Verfahren sieht des Weiteren vor, das Steuerbit in dem Register mit einem zweiten Zustand zu setzen. Der integrierte Halbleiterspeicher wird anschließend von dem zweiten externen Taktsignal angesteuert. Der zweite Zustand des Steuerbits bewirkt nunmehr, dass zur Erzeugung des internen Taktsignals die zweite Taktschaltung aktiviert wird.

Gemäß einer anderen Ausführungsform des erfindungsgemäßen Verfahrens zur Erzeugung eines Taktsignals zum Betreiben eines integrierten Halbleiterspeichers wird ein integrierter Halbleiterspeicher vorgesehen, der von einem externen Taktsignal ansteuerbar ist. Der integrierte Halbleiterspeicher weist eine Taktgeberschaltung auf, die einen Differenzverstärker mit einer steuerbaren Stromquelle zur Erzeugung eines Stroms, der in den Differenzverstärker eingespeist wird, umfasst. Erfindungsgemäß wird der integrierte Halbleiterspeicher mit einem externen Taktsignal angesteuert. Anschließend wird die Frequenz des externen Taktsignals ausgewertet. Der Strom, der von der steuerbaren Stromquelle in den Differenzverstärker eingespeist wird, wird erhöht, wenn die Frequenz des externen Taktsignals oberhalb einer Frequenzschwelle liegt. Umgekehrt wird der Strom, der von der steuerbaren Stromquelle in den Differenzverstärker eingespeist wird, erniedrigt, wenn die Frequenz des externen Taktsignals unterhalb der Frequenzschwelle liegt.

Weitere Ausführungsformen betreffend den integrierten Halbleiterspeicher und das Verfahren zur Erzeugung eines Taktsignals zum Betreiben des integrierten Halbleiterspeichers sind den Unteransprüchen zu entnehmen.

Die Erfindung wird im Folgenden anhand der Figuren, die Ausführungsbeispiele der vorliegenden Erfindung zeigen, näher erläutert. Es zeigen:
Figur 1 eine erste Ausführungsform einer integrierten Schaltung zur Erzeugung eines internen Taktsignals gemäß der Erfindung,
Figur 2 eine zweite Ausführungsform einer integrierten Schaltung zur Erzeugung eines internen Taktsignals gemäß der Erfindung,
Figur 3 eine dritte Ausführungsform einer integrierten Schaltung zur Erzeugung eines internen Taktsignals gemäß der Erfindung,
Figur 4 eine Ausführungsform einer integrierten Schaltung zur Erzeugung eines internen Taktsignals gemäß dem Stand der Technik,
Figur 5 zeitliche Verläufe von externen und internen Taktsignalen eines integrierten Halbleiterspeichers,
Figur 6 eine Ausführungsform einer Taktgeberschaltung zur Erzeugung eines internen Taktsignals gemäß dem Stand der Technik.

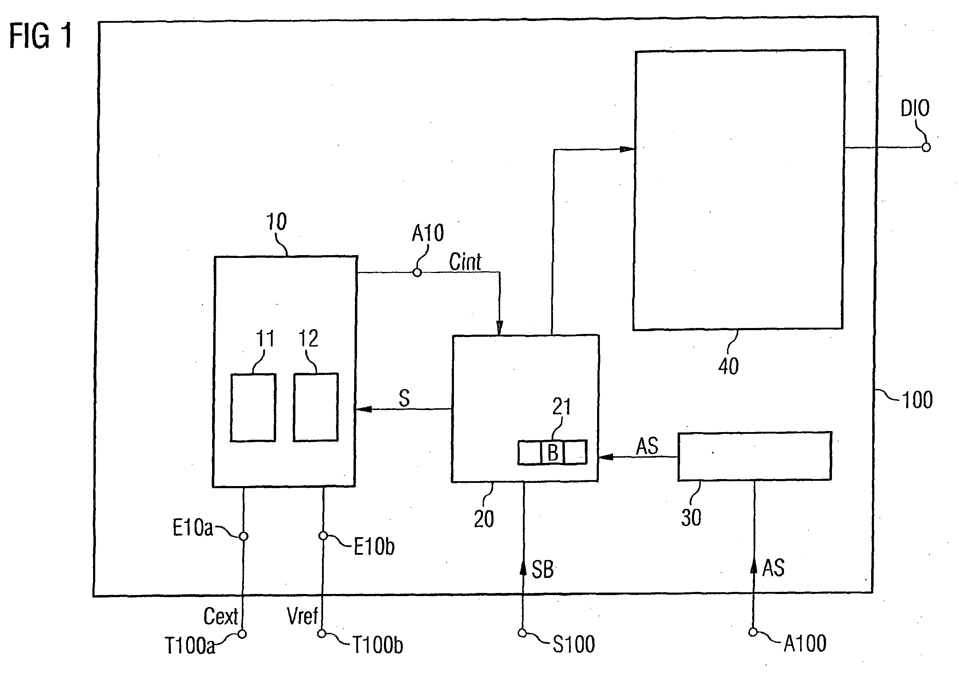

Die integrierten Halbleiterspeicher der Figuren 1, 2 und 3 weisen das bereits in der Figur 4 beschriebene Adressregister 30 zum Zwischenspeichern von Adressen AS sowie das Speicherzellenfeld 40 mit Speicherzellen auf, in die Daten über einen Datenanschluss DIO einlesbar bzw. aus denen Daten an dem Datenanschluss DIO auslesbar sind. Zur Funktionsweise dieser Schaltungskomponenten wird auf die Erläuterungen zu Figur 4 verwiesen.

Figur 1 zeigt eine erste Ausführungsform eines integrierten Halbleiterspeichers zur Erzeugung eines internen Taktsignals gemäß der Erfindung. Der integrierte Halbleiterspeicher weist neben dem Adressregister 30 und dem Speicherzellenfeld 40 eine Taktgeberschaltung 10 und eine Steuerschaltung 20 auf. Die Taktgeberschaltung 10 ist über einen ersten Eingangsanschluss E10a und einen zweiten Eingangsanschluss E10b mit einem externen Taktanschluss T100a zum Anlegen eines externen Taktsignals Cext und über einen zweiten Eingangsanschluss E10b mit einem Taktanschluss T100b des integrierten Halbleiterspeichers zum Anlegen eines Empfindlichkeitspegels Vref verbunden. Die Taktgeberschaltung 10 umfasst eine erste Taktschaltung 11 und eine zweite Taktschaltung 12.

Die erste Taktschaltung 11 hat eine kleinere Empfindlichkeitszeit als die zweite Taktschaltung 12. Da die Empfindlichkeitszeit diejenige Zeit ist, mit der die Taktgeberschaltung 10 mindestens mit einem hohen oder niedrigen Pegel des externen Taktsignals angesteuert werden muss, um ausgangsseitig den internen Takt mit dem ersten Pegel PE1 oder dem zweiten Pegel PE2 zu erzeugen, reagiert die zweite Taktschaltung nur auf langsame Änderungen des Pegels des externen Taktsignals Cext. Die erste Taktschaltung hingegen reagiert durch ihre kleinere Empfindlichkeitszeit auf kurzzeitige Schwankungen des externen Taktsignals Cext zwischen dem hohen Pegel PE1 und dem niedrigen Pegel PE2.

Die erste Taktschaltung 11 wird vorzugsweise dann eingesetzt, wenn der integrierte Halbleiterspeicher von einem externen Taktsignal mit einem großen Signal-/Rauschverhältnis und einer hohen Frequenz- und Phasenstabilität angesteuert wird. Die erste Taktschaltung 11 kommt also dann zum Einsatz, wenn der integrierte Halbleiterspeicher von einem externen Taktsignal mit einer hohen Güte angesteuert wird. Dies sind insbesondere externe Taktsignale, die mit einer hohen Frequenz, beispielsweise von einem Speichercontroller in einer Rechnerapplikation erzeugt werden.

Umgekehrt wird die zweite Taktschaltung 12 zur Erzeugung des internen Taktes verwendet, wenn der integrierte Halbleiterspeicher von einem externen Taktsignal mit einem kleinen Signal-/Rauschverhältnis beziehungsweise eine geringe Frequenz- und Phasenstabilität angesteuert wird. Dies ist insbesondere dann der Fall, wenn der integrierte Halbleiterspeicher beispielsweise zu Testzwecken von einem Testsystem mit einer niedrigen Frequenz angesteuert wird.

Die erste und zweite Taktschaltung erzeugen an einem Ausgangsanschluss A10 der Taktgeberschaltung 10 das interne Taktsignal Cint, das sie der Steuerschaltung 20 zur Steuerung der internen Chiplogik zuführt.

Die Steuerschaltung 20 weist eine Speichereinheit 21, beispielsweise ein Speicherregister, auf. In dem Speicherregister, das im Falle eines DRAM-Halbleiterspeichers vorzugsweise als ein Mode Register oder ein Extended Mode Register ausgebildet ist, ist ein Steuerbit B mit einem ersten Zustand, beispielsweise dem Zustand 1, oder einem zweiten Zustand, beispielsweise dem Zustand 0, abspeicherbar. In Abhängigkeit von dem Zustand des Steuerbits B steuert die Steuerschaltung 20 die Taktgeberschaltung 10 mit einem Steuersignal S an. Wenn das Steuerbit beispielsweise den logischen Zustand 1 aufweist, erzeugt die Steuerschaltung ausgangsseitig das Steuersignal mit einem ersten Zustand. Wenn hingegen in der Speichereinheit 21 das Steuerbit B mit dem zweiten Zustand gespeichert ist, steuert die Steuerschaltung 20 die Taktgeberschaltung 10 mit einem zweiten Zustand des Steuersignals S an. Wenn die Taktgeberschaltung von dem ersten Zustand des Steuersignals S angesteuert wird, wählt sie die erste Taktschaltung 11 zur Erzeugung des internen Taktsignals Cint aus, wohingegen sie bei Ansteuerung mit dem zweiten Zustand des Steuersignals S die zweite Taktschaltung 12 zur Erzeugung des internen Taktsignals Cint auswählt. Das Steuerbit B lässt sich durch Anlegen eines Steuersignals SB an den Steueranschluss S100 der Steuerschaltung 20 in der Speichereinheit 21 mit dem ersten oder zweiten Zustand abspeichern.

Wenn der integrierte Halbleiterspeicher beispielsweise in einer Rechnerapplikation betrieben wird und von einem Speichercontroller angesteuert wird, der im allgemeinen ein externes Taktsignal mit einer hohen Frequenz, einem großen Signal-Rauschverhältnis sowie einer hohen Frequenz- und Phasenstabilität vorgibt, so schreibt der Speichercontroller vor der Aktivierung des Halbleiterspeichers für einen Lese- und Schreibzugriff das Steuerbit B in das Speicherregister 21 mit dem ersten Zustand ein. Wenn der integrierte Halbleiterspeicher 100 hingegen zu Testzwecken von einem Tester, der im allgemeinen ein externes Taktsignal mit einer niedrigen Frequenz, einem kleinen Signal-/Rauschverhältnis beziehungsweise einer geringen Frequenz- und Phasenstabilität vorgibt, so programmiert der Tester über den Steueranschluss S100 in dem Speicherregister 21 das Steuerbit mit dem zweiten Zustand. Dadurch wird für den Einsatz des integrierten Halbleiterspeichers in einer Rechnerapplikation die erste Taktschaltung 11 zur Erzeugung des internen Taktsignals und zu Testzwecken die zweite Taktschaltung 12 zur Erzeugung des internen Taktsignals Cint verwendet.

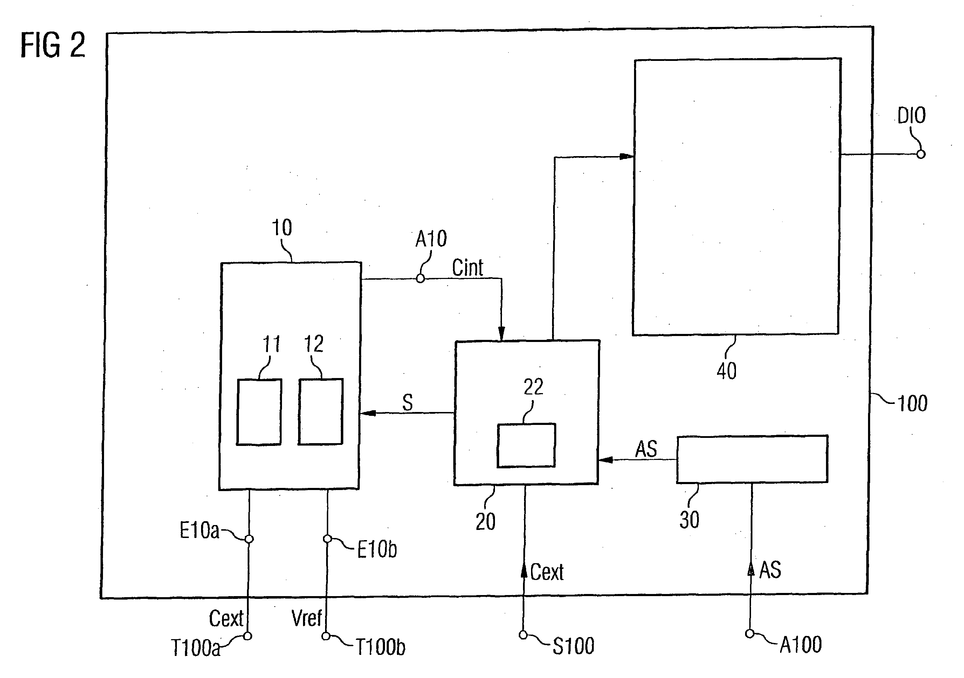

Figur 2 zeigt eine zweite Ausführungsform eines integrierten Halbleiterspeichers zur Erzeugung des internen Taktsignals Cint. Der integrierte Halbleiterspeicher weist eine Taktgeberschaltung 10 auf, die über einen ersten Eingangsanschluss E10a mit einem Taktanschluss T100a zum Anlegen eines externen Taktsignals Cext und über einen zweiten Eingangsanschluss E10b mit einem Taktanschluss T100b zum Anlegen eines Empfindlichkeitspegels Vref verbunden ist. Die Taktgeberschaltung 10 weist die bereits in der Figur 1 beschriebene erste Taktschaltung 11 und die zweite Taktschaltung 12 auf, wobei die erste Taktschaltung 11 eine kleinere Empfindlichkeitszeit TE hat als die zweite Taktschaltung 12. Zur Erzeugung des internen Taktsignals Cint an dem Ausgangsanschluss A10 der Taktgeberschaltung 10 lässt sich wahlweise die erste Taktschaltung 11 oder die zweite Taktschaltung 12 aktivieren. Die Aktivierung der ersten oder zweiten Taktschaltung erfolgt durch Ansteuerung der Taktgeberschaltung 10 mit einem ersten oder zweiten Zustand eines Steuersignals S, das von der Steuerschaltung 20 erzeugt wird.

Die Steuerschaltung 20 weist eine Auswerteschaltung 22 auf, der über einen Steueranschluss S100 das externe Taktsignal Cext zuführbar ist. Die Auswerteschaltung 22 ist derart ausgebildet, dass sie das Signal-/Rauschverhältnis des externen Taktsignals Cext und/oder die Frequenz und/oder die Frequenz- und Phasenstabilität des externen Taktsignals Cext auswertet. Die Auswerteschaltung 22 vergleicht dabei beispielsweise das Signal-/Rauschverhältnis und/oder die Frequenz und/oder die Frequenz- und Phasenstabilität mit Schwellwerten des Signal-/Rauschverhältnisses und/oder der Frequenz und/oder der Frequenz- und Phasenstabilität. Wenn das Signal-/Rauschverhältnis und/oder die Frequenz und/oder die Frequenz- und Phasenstabilität des externen Taktsignals über dem jeweiligen Schwellwert liegt, so erzeugt die Steuerschaltung ausgangsseitig das Steuersignal S mit dem ersten Zustand. Wenn hingegen das von der Auswerteschaltung 22 detektierte Signal-/Rauschverhältnis und/oder die Frequenz und/oder die Frequenz- und Phasenstabilität unterhalb des jeweiligen Schwellwertes liegt, erzeugt die Steuerschaltung 20 das Steuersignal S mit dem zweiten Zustand.

Die Taktgeberschaltung 10 aktiviert zur Erzeugung des internen Steuertakts Cint die erste Taktschaltung 11 mit der kleineren Empfindlichkeitszeit, wenn sie von der Steuerschaltung 20 mit dem ersten Zustand des Steuersignals S angesteuert wird. Wenn sie mit dem zweiten Zustand des Steuersignals S angesteuert wird, aktiviert sie die zweite Taktschaltung mit der größeren Empfindlichkeitszeit TE. In diesem Fall wird der integrierte Halbleiterspeicher 100 von einem qualitätsmäßig schlechteren externen Taktsignal, beispielsweise einem Taktsignal, das von einem Testsystem mit einem kleinen Signal-/Rauschverhältnis und/oder einer niedrigen Frequenz und/oder einer geringen Frequenz- und Phasenstabilität angesteuert wird. Bei der Aktivierung der ersten Taktschaltung mit der vergleichsweise kürzeren Empfindlichkeitszeit wird der integrierte Halbleiterspeicher 100 beispielsweise von einem Speichercontroller in einer Rechnerapplikation von einem externen Taktsignal mit einem verhältnismäßig großen Signal-/Rauschverhältnis und/oder einer verhältnismäßig hohen Frequenz und/oder einer verhältnismäßig großen Frequenz- und Phasenstabilität angesteuert. Die Taktgeberschaltung reagiert in diesem Fall empfindlicher auf Schwankungen des Pegels des externen Steuersignals.

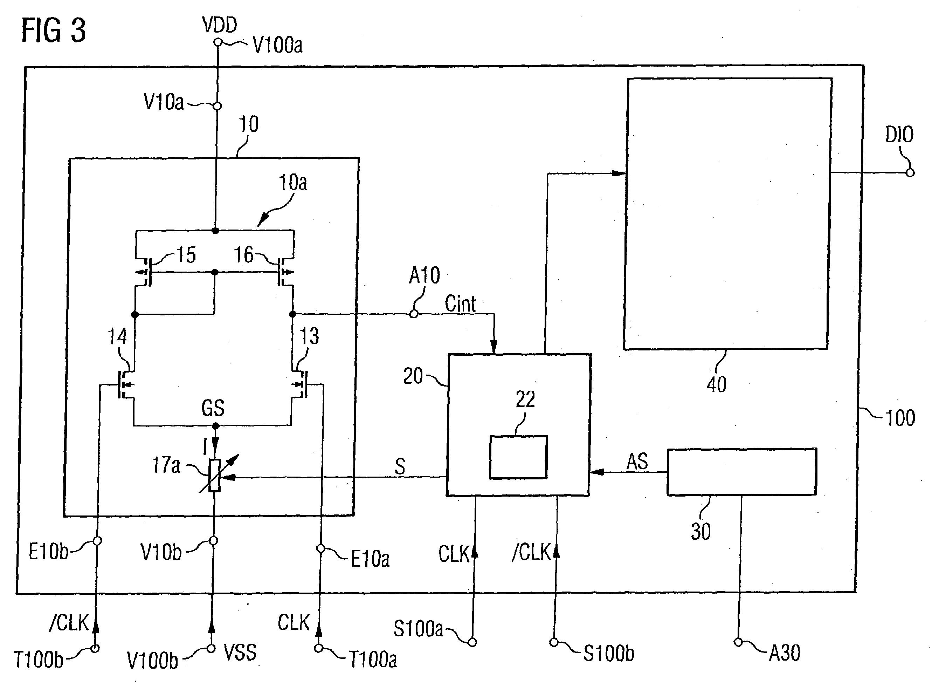

Figur 3 zeigt eine dritte Ausführungsform eines integrierten Halbleiterspeichers zur Erzeugung des internen Taktsignals Cint. Der integrierte Halbleiterspeicher weist eine Steuerschaltung 20 auf, der über einen ersten Steueranschluss S100a ein externes Taktsignal CLK und über einen zweiten Steueranschluss S100b ein dazu komplementäres externes Taktsignal /CLK zuführbar ist. Die Steuerschaltung 20 wird bei der Ausführungsform der Figur 3 also von einem externen Taktsignal, das aus zwei Einzelsignalen, die sich zueinander komplementär verhalten, angesteuert. Die Steuerschaltung 20 weist die bereits in der Figur 2 beschriebene Auswerteschaltung 22 zur Auswertung des Signal-/Rauschverhältnisses und/oder der Frequenz- und/oder der Frequenz- und Phasenstabilität des externen Taktsignals auf.

Die Taktgeberschaltung 10 ist über einen ersten Eingangsanschluss E10a mit einem ersten Taktanschluss T100a zum Anlegen des externen Taktsignals CLK und über einen zweiten Eingangsanschluss E10b mit einem zweiten Taktanschluss T100b des integrierten Halbleiterspeichers zum Anlegen des komplementären Taktsignals /CLK verbunden. Somit wird auch die Taktgeberschaltung 10 von einem externen Taktsignal, das aus den zwei zueinander komplementären Signalkomponenten CLK und /CLK gebildet wird, angesteuert. Die Taktgeberschaltung 10 ist über einen ersten Anschluss V10a mit einem Anschluss V100a des integrierten Halbleiterspeichers zum Anlegen einer Versorgungsspannung VDD und über einen zweiten Anschluss V10b mit einem - Anschluss V100b des integrierten Halbleiterspeichers zum Anlegen einer Bezugsspannung VSS verbunden. Die Taktgeberschaltung 10 ist als ein Differenzverstärker 10a ausgebildet. Der Differenzverstärker umfasst dabei die bereits in der Figur 6 beschriebenen Eingangstransistoren 13 und 14, deren Steueranschlüsse mit den Eingangsanschlüssen E10a und E10b verbunden sind, sowie die als Stromspiegel geschalteten Transistoren 15 und 16. Im Gegensatz zu der Ausführungsform der Figur 6 weist der Differenzverstärker 10a zwischen dem gemeinsamen Anschluss GS der beiden Eingangstransistoren 13 und 14 und dem Anschluss V10b eine gesteuerte Stromquelle, die in einer einfachen Ausführungsform als ein steuerbarer Widerstand 17a ausgeführt ist, auf. Die gesteuerte Stromquelle 17a ist durch das Steuersignal S, das von der Steuerschaltung 20 erzeugt wird, steuerbar.

Wenn die Auswerteschaltung 22 von einem externen Taktsignal CLK und /CLK mit einem kleinen Signal-/Rauschverhältnis und/oder einer niedrigen Frequenz und/oder einer geringen Frequenz- und Phasenstabilität angesteuert wird, steuert sie die steuerbare Stromquelle 17a über das Steuersignal S derart an, dass der von der gesteuerten Stromquelle dem Differenzverstärker 10a zur Verfügung gestellte Strom I abnimmt. Dazu wird beispielsweise der Widerstandswert des steuerbaren Widerstands 17a erhöht. Aufgrund des geringeren Stroms, der von der steuerbaren Stromquelle 17a in den Differenzverstärker 10a eingespeist wird, weist dieser eine geringere Empfindlichkeit gegenüber Pegelschwankungen des externen Taktsignals auf. Er reagiert beispielsweise erst dann auf einen Pegel des externen Taktsignals unterhalb der Empfindlichkeitsschwelle Vref, wenn der Pegel für eine lange Zeit unterhalb des Empfindlichkeitspegels liegt. Dadurch werden ungewollte Pegeländerungen des internen Taktsignals Cint in Folge kurzfristiger Schwankungen eines verrauschten externen Taktsignals ober- oder unterhalb dem Empfindlichkeitspegel Vref vermieden.

Wenn die Auswerteschaltung 22 hingegen von externen Taktsignalen CLK und /CLK mit einem großen Signal-/Rauschverhältnis und/oder einer hohen Frequenz und/oder einer hohen Frequenz- und Phasenstabilität angesteuert wird, so steuert sie die steuerbare Stromquelle 17a derart an, dass der Strom I, der in den Differenzverstärker 10a eingespeist wird, erhöht wird. Der Differenzverstärker 10A weist somit eine höhere Empfindlichkeit gegenüber Schwankungen des externen Taktsignals auf. Er reagiert durch seine kleine Empfindlichkeitszeit also bereits, wenn der Pegel des externen Taktsignals Cext kurzfristig unter- oder oberhalb dem Empfindlichkeitspegel Vref liegt.

### Bezugszeichenliste

- 10: Taktgeberschaltung
- 11, 12: Taktschaltungen
- 20: Steuerschaltung
- 21: Speichereinheit
- 22: Auswerteschaltung
- 30: Steuerschaltung
- 40: Speicherzellenfeld
- 15, 16: Stromspiegeltransistoren
- 13, 14: Eingangstransistoren
- 17a: gesteuerte Stromquelle
- 18: Latch
- 19: Inverter
- Cext: externes Taktsignal
- Cint: internes Taktsignal
- Vref: Referenzsignal
- SB: Steuersignal
- AS: Adresssignal
- S: Steuersignal
- E: Eingangsanschluss
- A: Ausgangsanschluss
- DIO: Datenein- und -ausgangsanschluss
- 100: integrierter Halbleiterspeicher
- CLK: Taktsignal
- /CLK: komplementäres Taktsignal
- VDD: Versorgungsspannung
- VSS: Bezugsspannung
- DS: Differenzsignal
- PE: Pegel des externen Taktsignals
- PI: Pegel des internen Taktsignals
- TE: Empfindlichkeitszeit
- TD: Impulsdauer
- BL: Bitleitung
- WL: Wortleitung
- SZ: Speicherzelle
- AT: Auswahltransistor
- SC: Speicherkondensator

## Patentansprüche

1. Integrierter Halbleiterspeicher
- mit einem Taktanschluss (T100a) zum Anlegen eines externen Taktsignals (Cext), das einen Taktsignalpegel (PE1, PE2) annimmt,
- mit einer Taktgeberschaltung (10), die zur Erzeugung eines internen Taktsignals (Cint) von dem externen Taktsignal (Cext) angesteuert wird,
- bei dem die Taktgeberschaltung (10) derart ausgebildet ist, dass sie das interne Taktsignal (Cint) mit einem ersten Pegel (PI1) erzeugt, wenn der Taktsignalpegel (PE1) des externen Taktsignals (Cext) oberhalb eines Empfindlichkeitspegels (Vref) der Taktgeberschaltung liegt und sie von dem Taktsignalpegel (PE1) des externen Taktsignals (Cext) mindestens für die Dauer einer Empfindlichkeitszeit (TE) der Taktgeberschaltung angesteuert wird,
- bei dem die Taktgeberschaltung (10) derart ausgebildet ist, dass sie das interne Taktsignal (Cint) mit einem zweiten Pegel (PI2) erzeugt, wenn der Taktsignalpegel (PE2) des externen Taktsignals (Cext) unterhalb des Empfindlichkeitspegels (Vref) liegt und sie von dem Taktsignalpegel (PE2) des externen Taktsignals (Cext) mindestens für die Dauer einer Empfindlichkeitszeit (TE) der Taktgeberschaltung angesteuert wird,
- mit einer Steuerschaltung (20) zur Steuerung der Taktgeberschaltung (10), die von dem externen Taktsignals (Cext) angesteuert wird,
- bei dem die Steuerschaltung (20) derart ausgebildet ist, dass sie die Empfindlichkeitszeit (TE) der Taktgeberschaltung (10) verändert.

2. Integrierter Halbleiterspeicher nach Anspruch 1,
- bei dem die Steuerschaltung (20) von einem ersten externen Taktsignal (Cext1) und von einem zweiten externen Taktsignal (Cext2) ansteuerbar ist,
- bei dem das erste externe Taktsignal (Cext1) ein höhere Frequenz als das zweite externe Taktsignal (Cext2) aufweist,
- bei dem die Steuerschaltung (20) derart ausgebildet ist, dass sie bei einer Ansteuerung mit dem ersten externen Taktsignal (Cext1) die Empfindlichkeitszeit (TE) der Taktgeberschaltung (10) verkürzt und bei einer Ansteuerung mit dem zweiten externen Taktsignal (Cext2) die Empfindlichkeitszeit (TE) der Taktgeberschaltung (10) verlängert.

3. Integrierter Halbleiterspeicher nach Anspruch 1,
- bei dem die Steuerschaltung (20) von einem ersten externen Taktsignal (Cext1) und von einem zweiten externen Taktsignal (Cext2) ansteuerbar ist,
- bei dem das erste externe Taktsignal (Cext1) ein größeres Signal-/Rauschverhältnis als das zweite externe Taktsignal (Cext2) aufweist,
- bei dem die Steuerschaltung (20) derart ausgebildet ist, dass sie bei einer Ansteuerung mit dem ersten externen Taktsignal (Cext1) die Empfindlichkeitszeit (TE) der Taktgeberschaltung (10) verkürzt und bei einer Ansteuerung mit dem zweiten externen Taktsignal (Cext2) die Empfindlichkeitszeit (TE) der Taktgeberschaltung (10) verlängert.

4. Integrierter Halbleiterspeicher nach Anspruch 1,
- bei dem die Steuerschaltung (20) von einem ersten externen Taktsignal (Cext1) und von einem zweiten externen Taktsignal (Cext2) ansteuerbar ist,
- bei dem das erste externe Taktsignal (Cext1) eine höhere Frequenz- und Phasenstabilität als das zweite externe Taktsignal (Cext2) aufweist,
- bei dem die Steuerschaltung (20) derart ausgebildet ist, dass sie bei einer Ansteuerung mit dem ersten externen Taktsignal (Cext1) die Empfindlichkeitszeit (TE) der Taktgeberschaltung (10) verkürzt und bei einer Ansteuerung mit dem zweiten externen Taktsignal (Cext2) die Empfindlichkeitszeit (TE) der Taktgeberschaltung (10) verlängert.

5. Integrierter Halbleiterspeicher nach einem der Ansprüche 1 bis 4,
- bei dem die Taktgeberschaltung (10) eine erste Taktschaltung (11) und eine zweite Taktschaltung (12) aufweist,
- bei dem die erste Taktschaltung (11) eine kleinere Empfindlichkeitszeit (TE) als die zweite Taktschaltung (12) aufweist.

6. Integrierter Halbleiterspeicher nach Anspruch 5, bei dem die Taktgeberschaltung (10) derart ausgebildet ist, dass sie das interne Taktsignal (Cint) durch die erste Taktschaltung (11) erzeugt, wenn die Steuerschaltung (20) von dem ersten externen Taktsignal (Cext1) angesteuert wird, und sie das interne Taktsignal (Cint) durch die zweite Taktschaltung (12) erzeugt, wenn die Steuerschaltung (20) von dem zweiten externen Taktsignal (Cext2) angesteuert wird.

7. Integrierter Halbleiterspeicher nach einem der Ansprüche 2 bis 4,
- bei dem die Taktgeberschaltung (10) einen Differenzverstärker (10a) aufweist,
- bei dem der Differenzverstärker (10a) der Taktgeberschaltung (10) einen ersten Eingangstransistor (13), einen zweiten Eingangstransistor (14) und eine steuerbare Stromquelle (17a) aufweist, die mit einem gemeinsamen Anschluss (GS) des ersten und zweiten Eingangstransistors verbunden ist,
- bei dem die Taktgeberschaltung (10) derart ausgebildet ist, dass die steuerbare Stromquelle (17a) einen hohen Strom an dem gemeinsamen Anschluss (GS) des ersten und zweiten Eingangstransistors erzeugt, wenn die Steuerschaltung (20) von dem ersten externen Taktsignal (Cext1) angesteuert wird, und die steuerbare Stromquelle (17a) einen niedrigen Strom an dem gemeinsamen Anschluss (GS) des ersten und zweiten Eingangstransistors erzeugt, wenn die Steuerschaltung (20) von dem zweiten externen Taktsignal (Cext2) angesteuert wird.

8. Integrierter Halbleiterspeicher nach einem der Ansprüche 2 bis 7,
- bei dem die Taktgeberschaltung (10) von der Steuerschaltung (20) mit einem Steuersignal (S) ansteuerbar ist,
- bei dem die Steuerschaltung (20) derart ausgebildet ist, dass sie die Taktgeberschaltung (10) mit einem ersten Zustand des Steuersignals (S) ansteuert, wenn sie von dem ersten externen Taktsignal (Cext1) angesteuert wird, und sie die Taktgeberschaltung (10) mit einem zweiten Zustand des Steuersignals (S) ansteuert, wenn sie von dem zweiten externen Taktsignal (Cext2) angesteuert wird.

9. Integrierter Halbleiterspeicher nach Anspruch 8,
- bei dem die Steuerschaltung (20) eine Speichereinheit (21) zur Speicherung eines Steuerbits (B) aufweist,
- bei dem die Steuerschaltung (20) derart ausgebildet ist, dass sie die Taktgeberschaltung (10) mit dem ersten Zustand des Steuersignals (S) ansteuert, wenn das Steuerbit (B) einen ersten Zustand aufweist, und sie die Taktgeberschaltung (10) mit dem zweiten Zustand des Steuersignals (S) ansteuert, wenn das Steuerbit (B) einen zweiten Zustand aufweist.

10. Integrierter Halbleiterspeicher nach Anspruch 8,
- bei dem die Steuerschaltung (20) eine Auswerteschaltung (22) aufweist,
- bei dem die Auswerteschaltung (22) derart ausgebildet ist, dass sie das externe Taktsignal (Cext1, Cext2) auswertet und das Steuersignal (S) mit dem ersten Zustand erzeugt, wenn sie von dem ersten externen Taktsignal (Cext1) angesteuert wird, und das Steuersignal (S) mit dem zweiten Zustand erzeugt, wenn sie von dem zweiten externen Taktsignal (Cext2) angesteuert wird.

11. Integrierter Halbleiterspeicher nach Anspruch 10, bei dem die Auswerteschaltung (22) derart ausgebildet ist, dass sie die Frequenz des externen Taktsignals (Cext) auswertet.

12. Integrierter Halbleiterspeicher nach Anspruch 10, bei dem die Auswerteschaltung (22) derart ausgebildet ist, dass sie das Signal-/Rauschverhältnis des externen Taktsignals (Cext) auswertet.

13. Integrierter Halbleiterspeicher nach Anspruch 10, bei dem die Auswerteschaltung (22) derart ausgebildet ist, dass sie die Frequenz- und Phasenstabilität des externen Taktsignals (Cext) auswertet.

14. Verfahren zur Erzeugung eines Taktsignals zum Betreiben eines integrierten Halbleiterspeichers, umfassend die folgenden Schritte:
- Vorsehen eines integrierten Halbleiterspeichers, der von einem externen Taktsignals (Cext) ansteuerbar ist, das einen Taktsignalpegel (PE1, PE2) annimmt,
- Vorsehen des integrierten Halbleiterspeichers mit einer ersten Taktschaltung (11) mit einer ersten Empfindlichkeitszeit und einem Empfindlichkeitspegel (Vref), bei dem die erste Taktschaltung (11) ausgangsseitig (A10) ein internes Taktsignal (Cint) mit einem ersten Pegel (PI1) erzeugt, wenn sie mindestens für die Dauer der ersten Empfindlichkeitszeit von dem Taktsignalpegel (PE1) des externen Taktsignals (Cext) angesteuert wird, der oberhalb des Empfindlichkeitspegels (Vref) der ersten Taktschaltung liegt, und ein internes Taktsignal (Cint) mit einem zweiten Pegel (PI2) erzeugt, wenn sie mindestens für die Dauer der ersten Empfindlichkeitszeit von dem Taktsignalpegel (PE2) des externen Taktsignals (Cext) angesteuert wird, der unterhalb des Empfindlichkeitspegels (Vref) der ersten Taktschaltung liegt,
- Vorsehen des integrierten Halbleiterspeichers mit einer zweiten Taktschaltung (12) mit einer zweiten Empfindlichkeitszeit und einem Empfindlichkeitspegel (Vref), bei dem die zweite Taktschaltung (12) ausgangsseitig (A10) das interne Taktsignal (Cint) mit dem ersten Pegel (PI1) erzeugt, wenn sie mindestens für die Dauer der zweiten Empfindlichkeitszeit von dem Taktsignalpegel (PE1) des externen Taktsignals (Cext) angesteuert wird, der oberhalb des Empfindlichkeitspegels (Vref) der zweiten Taktschaltung liegt, und ein internes Taktsignal (Cint) mit einem zweiten Pegel (PI2) erzeugt, wenn sie mindestens für die Dauer der zweiten Empfindlichkeitszeit von dem Taktsignalpegel (PE2) des externen Taktsignals (Cext) angesteuert wird, der unterhalb des Empfindlichkeitspegels (Vref) der zweiten Taktschaltung liegt,
- Vorsehen des integrierten Halbleiterspeichers, bei dem die erste Empfindlichkeitszeit der ersten Taktschaltung (11) kleiner als die zweite Empfindlichkeitszeit der zweiten Taktschaltung (12) ist,
- Vorsehen eines integrierten Halbleiterspeichers, der von einem ersten externen Taktsignal (Cext1) mit einer hohen Frequenz und von einem zweiten externen Taktsignal (Cext2) mit einer niedrigen Freuquenz ansteuerbar ist,
- Setzen eines Steuerbits (B) in einem Register (21) mit einem ersten Zustand,
- Ansteuern des integrierten Halbleiterspeichers mit dem ersten externen Taktsignal (Cext1),
- Aktivieren der ersten Taktschaltung (11) zur Erzeugung des internen Taktsignals (Cint),
- Setzen des Steuerbits (B) in dem Register (21) mit einem zweiten Zustand,
- Ansteuern des integrierten Halbleiterspeichers mit dem zweiten externen Taktsignal (Cext2),
- Aktivieren der zweiten Taktschaltung (12) zur Erzeugung des internen Taktsignals (Cint).

15. Verfahren zur Erzeugung eines Taktsignals zum Betreiben eines integrierten Halbleiterspeichers, umfassend die folgenden Schritte:
- Vorsehen eines integrierten Halbleiterspeichers, der von einem externen Taktsignal (Cext1, Cext2) ansteuerbar ist,
- Vorsehen des integrierten Halbleiterspeichers mit einer Taktgeberschaltung (10), die einen Differenzverstärker (10a) mit einer steuerbaren Stromquelle (17a) zur Erzeugung eines Stroms (I), der in den Differenzverstärker (10a) eingespeist wird, umfasst,
- Ansteuern des integrierten Halbleiterspeichers mit einem externen Taktsignal (Cext),
- Auswerten der Frequenz des externen Taktsignals (Cext),
- Erhöhen des Stroms (I), der von der steuerbaren Stromquelle (17a) in den Differenzverstärker (10a) eingespeist wird, wenn die Frequenz des externen Taktsignal (Cext) oberhalb einer Frequenzschwelle liegt,
- Erniedrigen des Stroms (I), der von der steuerbaren Stromquelle (17a) in den Differenzverstärker (10a) eingespeist wird, wenn die Frequenz des externen Taktsignal (Cext) unterhalb der Frequenzschwelle liegt.
